(19) Europäisches Patentamt
European Patent Office
Office européen des brevets

(11) EP 4 621 545 A1

(12) EUROPEAN PATENT APPLICATION

(43) Date of publication:
**24.09.2025 Bulletin 2025/39**

(21) Application number: **24218920.7**

(22) Date of filing: **11.12.2024**

(51) International Patent Classification (IPC):
***G06F 3/06*** *(2006.01)* ***G06F 12/02*** *(2006.01)*
***G11C 16/16*** *(2006.01)*

(52) Cooperative Patent Classification (CPC):
**G11C 16/16; G06F 3/0613; G06F 3/0625; G06F 3/064; G06F 3/0652; G06F 3/0679; G06F 12/0246;** G06F 2212/7205; G11C 16/32

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.03.2024 KR 20240039907**

(71) Applicant: **SK hynix Inc.**
**Bubal-eub**
**Icheon-si Gyeonggi-do 17336 (KR)**

(72) Inventors:
- **PARK, Jeong Sun**
**17336 Icheon-si, Gyeonggi-do (KR)**
- **LEE, Seon Ju**
**17336 Icheon-si, Gyeonggi-do (KR)**

(74) Representative: **Isarpatent**
**Patent- und Rechtsanwälte**
**Barth Hassa Peckmann & Partner mbB**
**Friedrichstraße 31**
**80801 München (DE)**

# (54) DATA STORAGE DEVICE WHICH ERASES BY GROUPING MEMORY BLOCKS AND METHOD OF OPERATING THE SAME

(57) The present disclosure provides a data storage device and method of operating the same. The data storage device may include a storage medium including a plurality of memory blocks; and a storage controller configured to combine memory blocks that are simultaneously accessed among the plurality of memory blocks to manage the combined memory blocks as a superblock. The storage controller erases a preliminary superblock for a subsequent write operation during a write time corresponding to a write operation mode of a selected superblock performing a write operation. The storage controller classifies memory blocks of the preliminary superblock into a plurality of erasing units each including a set number of the memory blocks, the plurality of erasing units being sequentially erased with a uniform erase interval between erase operations of the plurality of erasing units.

FIG. 1

10
100
200
DATA STORAGE DEVICE
260
210
STORAGE CONTROLLER
CH1
NVM_1
230
WT,RD
ADD
CH2
NVM_2
240
EXTERNAL DEVICE
30
ERASE MANAGEMENT CIRCUIT
CHn
NVM_n
250
DATA
BUFFER MEMORY DEVICE
220

EP 4 621 545 A1

## Description

BACKGROUND

1. Technical Field

Embodiments of the present disclosure relate to a data storage device and more particularly, to a data storage device which erases by grouping memory blocks and a method of operating the data storage device.

2. Related Art

A semiconductor memory device may include a plurality of memory cells connected between a plurality of word lines and a plurality of bit lines.

A flash memory device, represented by a non-volatile memory device, may define a set of the memory cells sharing the word line as a page. Further, the flash memory device may include a plurality of memory blocks. Each of the memory blocks may include a plurality of pages. A programming operation and a read operation of data into the memory cells of the flash memory device may be performed on a page-by-page basis. An erase operation of the flash memory device may be performed on a block-by-block basis. In addition, the flash memory device may combine some memory blocks which are simultaneously accessed and manage some memory blocks as a superblock, to improve an access speed.

However, the peak power required for erasing the super block may increase when the super block is erased. Currently, the memory blocks included in the super block may be classified into multiple memory groups, with each memory group including at least one of the memory blocks from the super block. The erase operation may be performed on a memory group-by memory group basis.

SUMMARY

According to embodiments of the present disclosure, there may be provided a data storage device. The data storage device may include a storage medium and a storage controller. The storage medium may include a plurality of memory blocks. The storage controller combines memory blocks that are simultaneously accessed among the plurality of memory blocks to manage the combined memory blocks as a superblock. The storage controller erases a preliminary superblock for a subsequent write operation during a write time set according to a write operation mode of a selected superblock performing a write operation. The storage controller classifies memory blocks of the preliminary superblock into a plurality of erasing units each including a set number of the memory blocks, the plurality of erasing units being sequentially erased with a uniform erase interval between erase operations of the plurality of erasing units.

According to embodiments of the present disclosure, there may be provided a data storage device. The data storage device may include a storage controller. The storage controller may combine memory blocks included in a storage medium, which are accessed simultaneously among the plurality of memory blocks to manage the combined memory blocks as a superblock. The storage controller may erase a preliminary superblock for a subsequent write operation during a write time set according to a write operation mode of a selected superblock performing a write operation. Further, the storage controller may group memory blocks of the preliminary superblock into a plurality of erasing units, and determine, based on an erase time per each erasing unit, a number of memory blocks per each erasing unit and an erase interval between erase operations of the plurality of erasing units to complete the erase operations of the plurality of erasing units of the preliminary superblock within the write time.

According to embodiments of the present disclosure,, there may be provided a method of operating a data storage device. The method may include combining memory blocks to be accessed simultaneously among a plurality of memory blocks to manage the combined memory blocks as a superblock; determining a write time set according to a write operation mode of a selected superblock performing a write operation; classifying a plurality of memory blocks of a preliminary superblock for a subsequent write operation into a plurality of erasing units; and erasing the plurality of erasing units with a uniform erase interval.

BRIEF DESCRIPTION OF THE DRAWINGS

The above and another aspects, features and advantages of the embodiments matter of the present disclosure will be more easily understood from the following detailed description taken in conjunction with the accompanying drawings, in which:

FIG. 1 is a block diagram illustrating a data processing system according to embodiments of the present disclosure;

FIG. 2 is a view illustrating a concept for managing a storage medium including a non-volatile memory device according to embodiments of the present disclosure;

FIG. 3 is a block diagram illustrating an erase management circuit according to embodiments of the present disclosure;

FIG. 4 is a diagram illustrating a concept for grouping memory blocks and determining erase intervals based on the type of write operation according to embodiments of the present disclosure;

FIG. 5A and 5B are graphs illustrating a peak power based on an erase operation of a preliminary superblock according to embodiments of the present disclosure;

FIG. 6 is a diagram illustrating a concept for grouping memory blocks and determining erase intervals based on the type of write operation according to embodiments of the present disclosure;

FIG. 7A and 7B are graphs illustrating a peak power based on an erase operation of a preliminary superblock according to embodiments of the present disclosure;

FIG. 8 is a diagram illustrating a concept for grouping memory blocks and determining erase intervals based on the type of write operation according to embodiments of the present disclosure;

FIGS. 9A and 9B are graphs illustrating a peak power based on an erase operation of a preliminary superblock according to embodiments of the present disclosure; and

FIG. 10 is a flowchart illustrating a method of operating a data storage device according to embodiments of the present disclosure.

DETAILED DESCRIPTION

Various embodiments of the present disclosure will be described in greater detail with reference to the accompanying drawings. The drawings are schematic illustrations of various embodiments and intermediate structures. As such, variations from the configurations and shapes of the illustrations as a result, for example, of manufacturing techniques and/or tolerances, are to be expected. Thus, the described embodiments should not be construed as being limited to the particular configurations and shapes illustrated herein but may include deviations in configurations and shapes which do not depart from the spirit and scope of the embodiments as defined in the appended claims.

Embodiments of the present disclosure are described herein with reference to cross-section and/or plan illustrations of embodiments of the present disclosure. However, the embodiments of the present disclosure should not be construed as limiting the inventive concept. Although a few embodiments of the present disclosure will be shown and described, it will be appreciated by those of ordinary skill in the art that changes may be made in these embodiments without departing from the principles and spirit of the embodiments.

As used herein, the term "configured" refers to a size, shape, material composition, orientation, a connection structure between components and arrangement of one or more of at least one structure and at least one apparatus facilitating operation of one or more of the structure and the apparatus in a predetermined way.

As used herein, the singular forms "a," "an," and "the" are intended to include the plural forms as well, unless the context clearly indicates otherwise.

As used herein, the phrase "interfaced with", "coupled to" and "connected to" refer to structures operatively connected with each other, such as electrically connected through a direct contact or through an indirect connection media (e.g., by way of another structure).

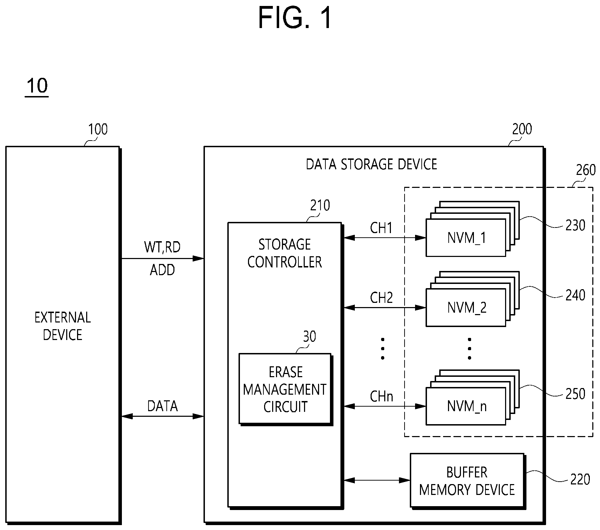

FIG. 1 is a block diagram illustrating a data processing system 10 according to embodiments of the present disclosure.

Referring to FIG. 1, the data processing system 10 may include an external device 100 and a data storage device 200.

The external device 100 may include at least one processor. The external device 100 may be a processor itself, or an electronic device or system including a processor. The external device 100 may be referred to as a host.

The data storage device 200 may include a storage controller 210, a buffer memory device 220 and a storage medium 260. The storage medium 260 may include a plurality of non-volatile memory devices 230, 240 and 250.

The external device 100 may transmit a write request including a write command WT, an address ADD and write data DATA to the data storage device 200 for writing data. When the data storage device 200 receives the write request, the data storage device 200 may control the storage medium 260 to program the write data.

The external device 100 may transmit a read request including a read command RD and an address ADD to the data storage device 200 for reading data. The data storage device 200 may read the read-requested data from the storage medium 260 and transmit the read-requested data to the external device 100 as data DATA.

The data storage device 200 not only may perform read and write operations according to external requests, such as the read request and the write request, but also may read and write data from/to the storage medium 260 for performing internal operations of the data storage device 200. The internal operations of the data storage device 200 may include a housekeeping operation performed regardless of the external requests from the external device 100. For example, the housekeeping operation may include a garbage collection operation, a wear-leveling operation or a read reclaim operation. The data storage device 200 may efficiently use a storage space of the storage medium 260 and/or ensure a reliability of data stored in the storage medium 260 by the housekeeping operation.

The buffer memory device 220 may temporarily store data transmitted between the external device 100 and the data storage device 200 during the write operation or the read operation.

The storage controller 210 may interface between the external device 100 and the data storage device 200. The storage controller 210 may include an erase management circuit 30.

The data storage device 200 may include at least one superblock. For example, operations of the data storage device 200 may be performed on a superblock-by-superblock basis. For example, a superblock where a write operation will be performed in a subsequent step should be erased based on a write operation mode or type of a superblock in a write operation.

The time required for the write operation may vary depending on the write operation mode. Thus, during the write operation of the superblock, the erase operation of the superblock for a subsequent write operation should be completed.

The write operation mode may be categorized into a sequential write operation and a random write operation.

For example, the sequential write operation may be performed by at least one of the write request of the external device 100 and the internal operations of the data storage device 200.

For example, the random write operation may be performed by the write request of the external device 100. Alternately, the random write operation may be performed by the internal operations of the data storage device 200.

As shown in Table 1, a write time may vary based on the write operation modes. Further, the write time may vary based on the write operation modes and a state of the data storage device 200.

[Table 1]

| Types of write operations | Write time |
|---|---|
| Sequential write operation according to the request of the external device or the internal operations of the data storage device | a |
| Random write operation according to the request of the external device | b |
| a random write operation according to the internal operation | c |

The data storage device 200 may be managed with super blocks having different size. In one embodiment, the data storage device 200 may be managed with a first super block having a first number of memory blocks and a second super block having a second number of memory blocks different from the first number. The first super block and the second super block may have different write time for the same type of write operation. Moreover, a power consumption of the first super block and the second super block may be different during the erase operation.

The erase management circuit 30 may determine a number of the memory blocks that are included in an erasing unit and an erase interval between the erasing units.

For example, the erasing manage circuit 30 may set the erasing unit to guarantee a write time for performing a subsequent write operation (hereinafter, a second write operation) of a preliminary superblock, based on the write time for performing a current write operation (hereinafter, a first write operation) of the superblock. The erasing unit may be obtained by grouping a set number of memory blocks constituting the preliminary superblock.

In various embodiments, the erase management circuit 30 may group the memory blocks based on the number of the memory blocks in the preliminary superblock and an erase time per memory block, so that the erase intervals between the erasing units are uniform.

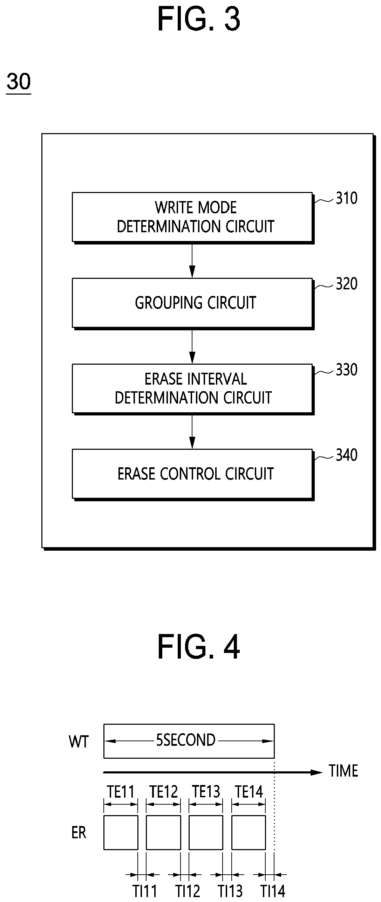

A specific description of the erase management circuit 30 will be described later with reference to FIG. 3.

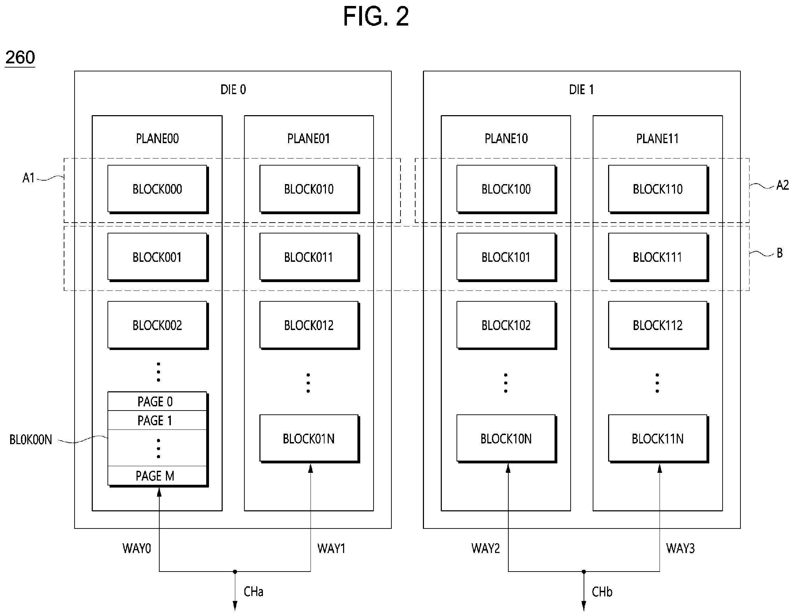

FIG. 2 is a view illustrating a concept for managing a storage medium including a non-volatile memory device according to embodiments of the present disclosure.

The non-volatile memory device included in the storage medium 260 may include at least one die. For example, the die may include a plurality of dies DIE 0 and DIE 1. Each of the die DIE 0 and DIE 1 may include at least one plane. For example, the die DIE 0 may include a plurality of planes PLANE00/PLANE01 and the die DIE 1 may include a plurality of planes PLANE10/PLANE11. The plurality of planes PLANE00/PLANE01 and PLANE10/PLANE11 may include a plurality of memory blocks BLOCK000-BLOCK00N, BLOCK010-BLOCK01N, BLOCK100-BLOCK10N and BLOCK110-BLOCK11N, respectively. Each of the memory blocks BLOCK000-BLOCK00N, BLOCK010-BLOCK01N, BLOCK100-BLOCK10N and BLOCK110-BLOCK11N may include a plurality of pages PAGE 0-PAGE M.

The storage medium 260 may input/output data through channels CHa and CHb. Each channel CHa and CHb may input/output the data in an interleaving manner. Each channel CHa and CHb may be connected to a respective plane PLANE00/PLANE01 and PLANE10/PLANE11, for example, by branching into a plurality of paths WAY0, WAY1, WAY2 and WAY3 sharing the channel CHa and CHb.

Referring to FIG. 2, each of the dies DIE 0 and DIE 1 may be connected to the independent channels CHa and CHb, respectively, and each of the planes PLANE00/PLANE01 and PLANE10/PLANE11 may be connected to the paths WAY0, WAY1, WAY2 and WAY3 branched from each channel CHa and CHb, respectively. However, a configuration of the non-volatile memory device is not limited to this embodiment.

The storage controller 210 may include at least one superblock by grouping simultaneously accessible memory blocks of a plurality of the memory blocks.

For example, the superblock may include a group A1 or A2 of the memory blocks BLOCK000 and BLOCK010 or BLOCK100 and BLOCK110 in different planes PLANE00/PLANE01 or PLANE10/PLANE11 of within the same die DIE 0 or DIE 1. Alternately, the superblock may include a group B of memory blocks BLOCK001, BLOCK011, BLOCK101 and BLOCK111 in different planes PLANE00 to PLANE11 and different dies DIE 0 and DIE 1.

FIG. 3 is a block diagram illustrating an erase management circuit based on embodiments of the present disclosure.

Referring to FIG. 3, the erase management circuit 30 may include a write mode determination circuit 310, a grouping circuit 320, an erase interval determination circuit 330 and an erase control circuit 340.

As data is written in a selected superblock, a preliminary superblock for a subsequent write operation may be erased to prepare the subsequent write operation in the preliminary superblock.

Since write times vary based on write operation modes of the superblocks, it is advantageous for an erase time of the preliminary superblock to be shorter or equal to a writing time of the selected superblock for a current write operation.

Further, because power consumption of the data storage device 200 may increase proportionally to the number of memory blocks being simultaneously erased, the erasing unit of the preliminary superblock may be grouped to include the minimum number of the memory blocks being simultaneously erased. A uniform erase interval may be provided between the erasing units to obtain a steady performance of the data storage device 200.

The write mode determination circuit 310 may determine a write time based on a write operation mode of the selected superblock. For example, the write operation mode may be categorized as a sequential write operation by the request of the external device 100 or the internal operation of the data storage device 200, the random write operation by the request of the external device 100 and the random write operations by the internal operation of the data storage device 200.

The grouping circuit 320 may group memory blocks of the preliminary superblock that are simultaneously erased, to define an erasing unit. The erasing unit may include the minimum number of the memory blocks, which are simultaneously erased.

For example, a write time may be determined by Equation 1 below.

Equation 1

$$T > E * (B/X) \text{ (where, X is the smallest natural number satisfying Equation 1)}$$

In Equation 1, T is a write time, E is an erase time per memory block, and B is the number of the memory blocks in the preliminary superblock, and X is the number of the memory blocks of the erasing unit which are simultaneously erased.

Therefore, the number of the erasing units in the preliminary superblock may be determined as the (B/X).

The erase interval determination circuit 330 may determine an erase interval IG between the erasing units based on Equation 3, such that an idle time I satisfying Equation 2 is uniformly distributed between the erasing units.

Equation 2

$$T = I+E*(B/X)$$

Equation 3

$$IG = I/(B/X) \text{ or } IG = I/((B/X)-1)$$

The erase control circuit 340 may control the storage medium 260 to erase the preliminary superblock based on the erase interval IG determined by the erase interval determination circuit 330 and the erasing unit determined by the grouping circuit 320.

FIG. 4 is a diagram illustrating a concept for grouping memory blocks and determining erase intervals based on the write operation mode according to embodiments of the present disclosure. In this embodiment, a write operation mode is a sequential write operation.

Referring to FIG. 4, for example, a write time T of the sequential write operation WT is 5 seconds, a number B of memory blocks in a preliminary superblock is 4, and an erase time E by the memory block is 1 second, a number X of the memory blocks by an erasing unit may be determined to be 1 based on Equation 1.

Since an idle time I is 1 second based on Equation 2, an erase interval IG may be determined to be, for example, 0.25 seconds.

For example, since the preliminary superblock includes four erasing units, an erasing process of the preliminary superblock may repeat four times a basic erasing including an erasing of an erasing unit with one memory block for 1 second and stopping the erase operation for 0.25 seconds (TE11->TI11->TE12->TI12->TE13->TI13->TE14->TI4). Thus, an erase ER of the preliminary superblocks is performed within the sequential write operation WT which is 5 seconds.

If the erase interval IG is determined as I/((B/X)-1), the last erase interval TI14 may be omitted.

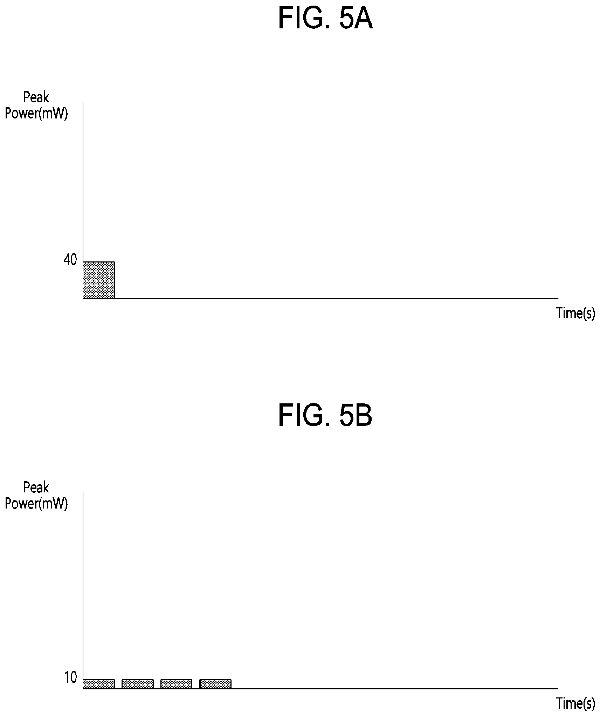

FIG. 5A and 5B are graphs illustrating a peak power based on an erase operation of a preliminary superblock according to embodiments of the present disclosure.

FIG. 5A shows a peak power when simultaneously erasing all four memory blocks of the preliminary superblock of FIG.4. FIG. 5B shows a peak power when the preliminary superblock is grouped into a plurality of erasing units and erased at a uniform interval of FIG. 4.

When an erase power by a memory block is 10mW and the four memory blocks included in the preliminary superblock are simultaneously erased, the peak power per the erase operation of the preliminary superblock is 40mW, as shown in FIG. 5A.

When the erase power by the memory block is 10mW and the four erasing units each including one memory block are sequentially erased with an erase interval (for example, 0.25 seconds) between the erase operations of the erasing units in the preliminary superblock, the peak power per the erase operation of the preliminary superblock is reduced to 10mW, as shown in FIG. 5B, which may reduce an instantaneous power consumption.

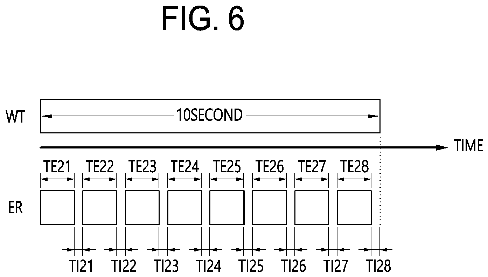

FIG. 6 is a diagram illustrating a concept for grouping memory blocks and determining erase intervals based on a write operation mode according to embodiments of the present disclosure. In this embodiment, a write operation mode is a random write operation based on internal operations of a data storage device (hereinafter, internal random write operation).

For example, when a write time T of the internal random write operation WT is 10 seconds, a number B of memory blocks in a preliminary superblock is 8, and an erase time E per the memory block is 1 second, a number X of memory blocks of an erasing unit of the preliminary superblock may be determined to be 1 based on Equation 1.

Since the idle time I is 2 seconds according to Equation 2, the erase interval IG may be determined to be, for example, 0.25 seconds.

For example, since the preliminary superblock includes eight erasing units, an erasing process of the preliminary superblock may repeat eight times a basic erasing including an erasing of an erasing unit with one memory block for 1 second and stopping the erase operation for 0.25 seconds (TE21->TI21->TE22->TI22->TE23->TI23->TE24->TI24->TE25->TI25->TE26->TI26->TE27->TI27->TE28->TI28). Thus, an erase ER of the preliminary superblocks is performed within the internal random write operation WT which is 10 seconds.

If the erase interval IG is determined as I/((B/X)-1), the last erase interval TI28 may be omitted.

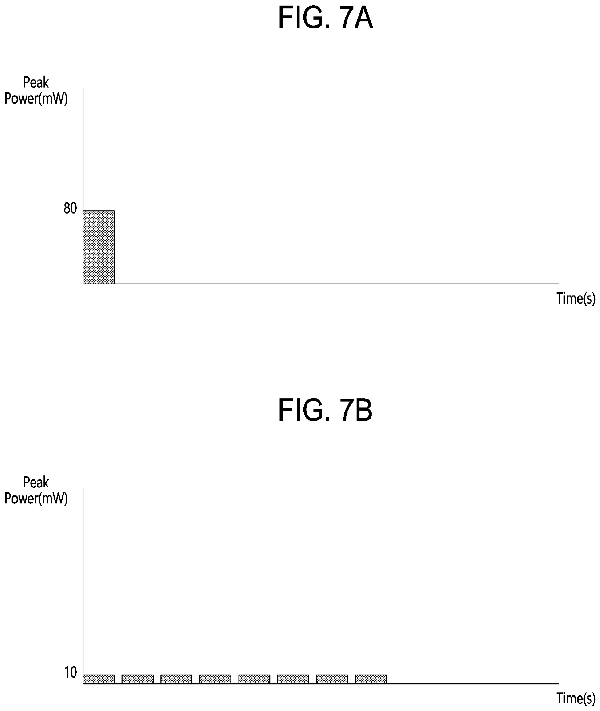

FIG. 7A and 7B are graphs illustrating a peak power based on an erase operation of a preliminary superblock according to embodiments of the present disclosure.

FIG. 7A shows the peak power when simultaneously erasing all eight memory blocks of the preliminary superblock of FIG. 6. FIG. 7B shows the peak power when the preliminary superblock is grouped into a plurality of erasing units and erased at a uniform interval of FIG. 6.

When an erase power by a memory block is 10mW and the eight memory blocks included in the preliminary superblock are simultaneously erased, the peak power per the erase operation of the erasing units in the preliminary superblock is 80mW/second, as shown in FIG. 7A.

When the erase power by the memory block is 10mW and the four erasing units each including one memory block are sequentially erased with an erase interval (for example, 0.25 seconds) between the erase operations of the erasing units, the peak power per the erase operation of the preliminary superblock is reduced to 10mW, as shown in FIG. 7B, which may reduce an instantaneous power consumption.

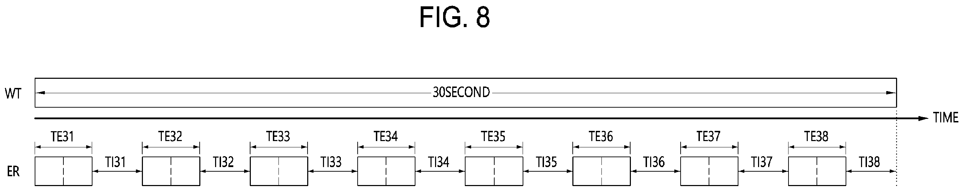

FIG. 8 is a diagram illustrating a concept of grouping memory blocks and determining erase intervals based on a write operation mode according to embodiments of the present disclosure. In this embodiment, a write operation mode is a random write operation based on requests of an external device 100 (hereinafter, external random write operation).

For example, when a write time T of the external random write operation WT is 30 seconds, a number B of memory blocks in a preliminary superblock is 16, and an erase time E per the memory block is 2 seconds, the number X of memory blocks per an erasing unit of the preliminary superblock may be determined to be 2 based on Equation 1.

Since an idle time I is 14 seconds according to Equation 2, the erase interval IG may be determined to be, for example, 1.75 seconds.

For example, since the preliminary superblock includes eight erasing units, an erasing process of the preliminary superblock may repeat eight times a basic erasing including an erasing of an erasing unit with two memory blocks for 2 seconds and stopping the erase operation for 1.75 seconds (TE31->TI31->TE32->TI32->TE33->TI33->TE34->TI34->TE35->TI35->TE36->TI36->TE37-> TI37->TE38->TI38). Thus, an erase ER of the preliminary superblocks is performed within the external random write operation WT which is 30 seconds.

If the erase interval IG is determined as I/((B/X)-1), the last erase interval TI28 may be omitted.

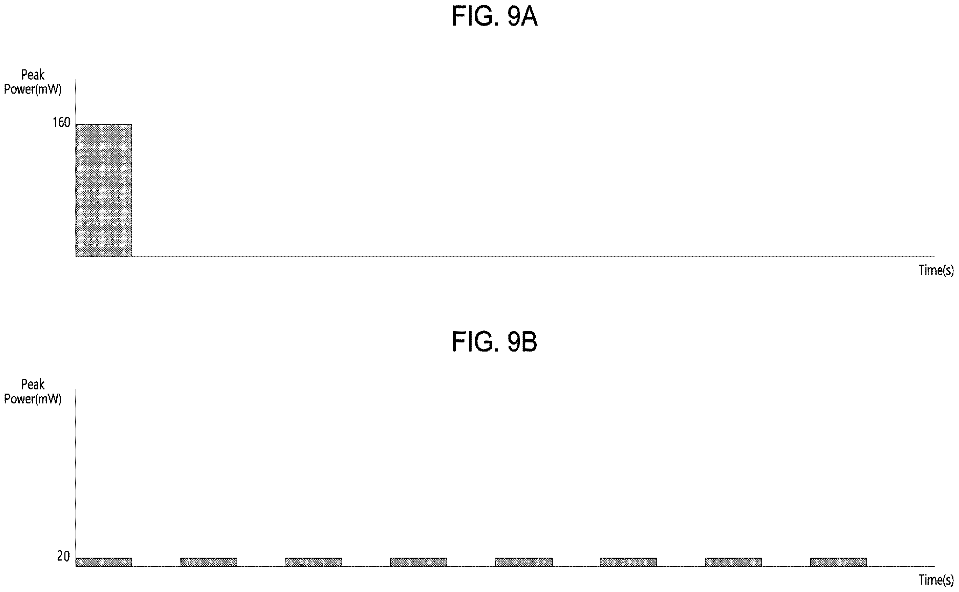

FIG. 9A and 9B are graphs illustrating a peak power based on an erase operation of a preliminary superblock according to embodiments of the present disclosure.

FIG. 9A shows the peak power when simultaneously erasing all sixteen memory blocks of the preliminary superblock of FIG. 8. FIG. 9B shows the peak power when the preliminary superblock is grouped into a plurality of erasing units and erased at a uniform interval of FIG. 8.

When an erase power by a memory block is 10mW and the sixteen memory blocks included in the preliminary superblock are simultaneously erased, the peak power per the erase operation of the preliminary superblock is 160mW, as shown in FIG. 9A.

When the erase power by the memory block is 10mW, the sixteen memory blocks of the preliminary superblocks are grouped into the eight erasing units each including two memory blocks, and the eight erasing units are sequentially erased with an erase interval (for example, 1.75 seconds) between the erase operations of the erasing units in the preliminary superblock, the peak power per the erase operation of the preliminary superblock may be reduced to 20mW, as shown in FIG. 9B, which may reduce an instantaneous power consumption.

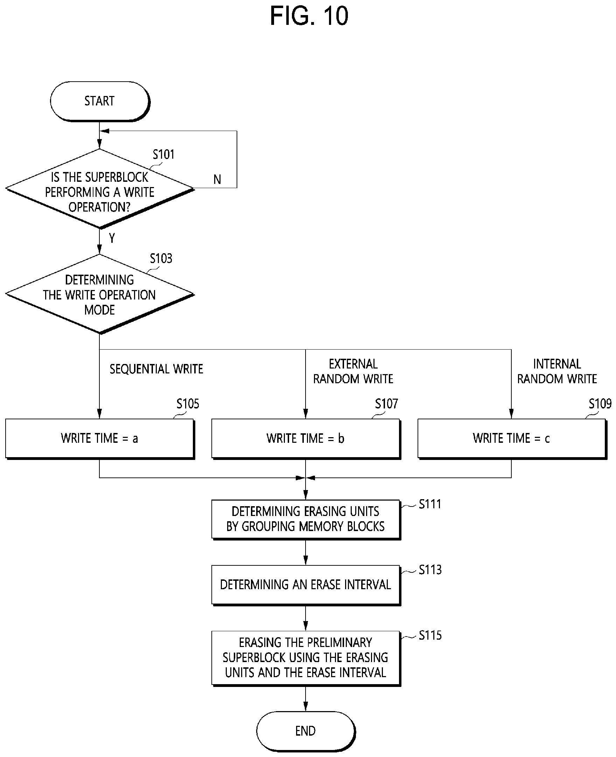

FIG. 10 is a flowchart illustrating a method of operating a data storage device based on embodiments of the present disclosure.

The erase management circuit 30 of the storage controller 210 may monitor whether a superblock is in a write operation (operation S101).

When the superblock is in the write operation (S101:Y), the erase management circuit 30 may determine a write operation mode of the superblock which is currently being processed (operation S103).

When the superblock is not in the write operation (S101:N), the erase management circuit 30 may repeat the operation S101.

When the write operation mode of the superblock is a sequential write operation (S103: sequential write) as a determining result, the erase management circuit 30 may set a write time "a" to the sequential write operation (operation S105). For example, the write time "a" may be an erase time of a preliminary superblock to be erased for a subsequent write operation.

If the write operation mode of the superblock in the write operation is an external random write operation as a determining result (S103: external random write), the erase management circuit 30 may set a write time "b" to the external random write operation (operation S107).

If the write operation mode of the superblock in the write operation is an internal random write operation as a determining result (S103: internal random write), the erase management circuit 30 may set a write time "c" to the internal random write operation (operation S109).

After the write time "a", "b", or "c" is set (the operation S105, S107 or S109) according to the write operation mode, the erase management circuit 30 may define at least one erasing unit in the preliminary superblock, by grouping memory blocks in the preliminary superblock such that the number of memory blocks being simultaneously erased is minimized (operation S111).

When the number of erasing units of the preliminary superblock is determined, the erase management circuit 30 may determine an erase interval between erase operations of the erasing units such that the erase intervals are uniform (operation S113).

The erase management circuit 30 may control the storage medium 260 to erase the preliminary superblocks using the erasing units and the erase interval determined in the operation S113 (operation S115).

As is well known, a peak power consumption increases proportionally to the number of memory blocks being simultaneously erased. According to the embodiments, the data storage device may obtain a steady performance as memory blocks in a preliminary superblock are grouped into erasing units and erased by an erasing unit-by-erasing unit. Especially, each of the erasing units includes the minimum number of the memory blocks being simultaneously erased, and an erasing interval between erasing units is uniform.

A performance-consistency of the data storage device 200 may be measured by the lowest Input Output Per Second (IOPS) relative to the average IOPS, and the performance-consistency may be evaluated based on how evenly the IOPS are measured when measuring IOPS over a period of time.

After a data storage device enters a sustain state, its program time (tPROG) or erase time changes, and frequent internal operations, such as garbage collection, can cause uneven IOPS, resulting in inconsistent performance.

According to embodiments, the memory blocks of a preliminary superblock for a subsequent write operation are grouped into erasing units, and the preliminary superblock is erased by an erasing unit-by-erasing unit. Especially, each of the erasing units includes the minimum number of the memory blocks being simultaneously erased with an erasing interval between erasing units to minimize a peak power and ensure a performance- consistency.

As such, those skilled in the art to which the embodiments of the present disclosure belong will understand that the invention may be practiced in other specific forms without altering its technical idea or essential features. It should therefore be understood that the embodiments described above are illustrative in all respects and are not intended to be limiting. The scope of the present disclosure is indicated by the following claims rather than by the detailed description above, and all modifications or variations derived from the meaning and scope of the claims and their equivalents are to be construed as being within the scope of the present disclosure. Furthermore, the embodiments may be combined to form additional embodiments.

## Claims

**1.** A data storage device comprising:

a storage medium including a plurality of memory blocks; and
a storage controller configured to combine memory blocks that are simultaneously accessed among the plurality of memory blocks to manage the combined memory blocks as a superblock,
wherein the storage controller is configured to erase a preliminary superblock for a subsequent write operation during a write time set according to a write operation mode of a selected superblock performing a write operation, and classify memory blocks of the preliminary superblock into a plurality of erasing units each including a set number of the memory blocks, the plurality of erasing units being sequentially erased with a uniform erase interval between erase operations of the plurality of erasing units.

**2.** The data storage device of claim 1, wherein the storage controller is configured to determine the set number of the memory blocks of each erasing unit, the set number being a minimum number of the memory blocks which are simultaneously erased in each erasing unit.

**3.** The data storage device of claim 1, wherein the storage controller is configured to manage the preliminary superblock to complete erase operations of the plurality of erasing units within the write operation of the selected superblock.

**4.** The data storage device of claim 1, wherein the write operation mode is one of a sequential write operation, a random write operation based on an external request and a random write operation based on an internal operation of the data storage device.

**5.** The data storage device of claim 1,

wherein a power consumption of an erase operation of the preliminary superblock is determined by a product of an erase power per the memory block and a number of memory blocks being simultaneously erased, and
the storage controller configures the erasing unit to satisfy that a power consumption of each of the erase operations of the erasing units is less than a power consumption consumed when all memory blocks of the preliminary superblock are simultaneously erased.

**6.** The data storage device of claim 1,

wherein the storage controller is configured to manage a first super block combining a first number of memory blocks and a second super block combining a second number of memory blocks different from the first number, and
the first super block and the second super block have different write time for the same write operation mode.

**7.** The data storage device of claim 1,

wherein the storage controller is configured to manage a first super block combining a first number of memory blocks and a second super block combining a second number of memory blocks different from the first number, and
a power consumption of the first super block and the second super block are different during the erase operation.

**8.** A data storage device comprising:
a storage controller configured to:

combine memory blocks included in a storage medium, which are accessed simultaneously among the plurality of memory blocks to manage the combined memory blocks as a superblock,
erase a preliminary superblock for a subsequent write operation during a write time set according to a write operation mode of a selected superblock performing a write operation,
group memory blocks of the preliminary superblock into a plurality of erasing units, and
determine, based on an erase time per each erasing unit, a number of memory blocks per each erasing unit and an erase interval between erase operations of the plurality of erasing units to complete the erase operations of the plurality of erasing units of the preliminary superblock within the write time.

**9.** The data storage device of claim 8,

wherein the storage controller is configured to manage a plurality of super blocks having different size, and the write time of each super block is set differently according to the size of superblock for the same write operation mode.

**10.** The data storage device of claim 8,

wherein the storage controller is configured to manage a plurality of super blocks having different size, and the write time of each super block is set differently according to the size of superblock for the same write operation mode.
a power consumption of each super block is different during the erase operation.

**11.** A method of operating a data storage device, the method comprising:

combining, by a storage controller, memory blocks to be accessed simultaneously among a plurality of memory blocks to manage the combined memory blocks as a superblock;
determining, by the storage controller, a write time set according to a write operation mode of a selected superblock performing a write operation;
classifying , by the storage controller, a plurality of memory blocks of a preliminary superblock for a subsequent write operation into a plurality of erasing units; and
erasing , by the storage controller, the plurality of erasing units with a uniform erase interval.

**12.** The method of claim 11, wherein, each of the plurality of erasing units includes a minimum number of memory blocks that are simultaneously erased.

**13.** The method of claim 11, wherein the erase operations of the plurality of erasing units of the preliminary superblock are completed within the write time.

**14.** The method of claim 11, wherein the write operation mode is one of a sequential write operation, a random write operation based on an external request and a random write operation based on an internal operation of the data storage device.

**15.** The method of claim 11,
wherein a power consumption of an erase operation of the preliminary superblock is determined by a product of an erase power per the memory block and a number of memory blocks being simultaneously erased, and
wherein classifying a plurality of memory blocks of a preliminary superblock comprises configuring the erasing unit to satisfy a power consumption of the erase operations of each of the erasing units is less than a power consumption consumed when all memory blocks of the preliminary superblock are simultaneously erased.

**16.** The method of claim 11, further comprising:

managing, by the storage controller, a first super block combining a first number of memory blocks and a second super block combining a second number of memory blocks different from the first number, and
the first super block and the second super block have different write time for the same write operation mode.

**17.** The method of claim 11, further comprising:

managing, by the storage controller, a first super block combining a first number of memory blocks and a second super block combining a second number of memory blocks different from the first number, and

a power consumption of the first super block and the second super block are different during the erase operation.

FIG. 1

10
100
EXTERNAL DEVICE
WT,RD
ADD
DATA
200
DATA STORAGE DEVICE
260
210
STORAGE CONTROLLER
30
ERASE MANAGEMENT CIRCUIT
CH1
CH2
CHn
NVM_1
NVM_2
NVM_n
230
240
250
BUFFER MEMORY DEVICE
220

FIG. 2
260
A1
A2
B
DIE 0
DIE 1
PLANE00
PLANE01
PLANE10
PLANE11
BLOCK000
BLOCK001
BLOCK002
PAGE 0
PAGE 1
PAGE M
BLOK00N
BLOCK010
BLOCK011
BLOCK012
BLOCK01N
BLOCK100
BLOCK101
BLOCK102
BLOCK10N
BLOCK110
BLOCK111
BLOCK112
BLOCK11N
WAY0
WAY1
WAY2
WAY3
CHa
CHb

FIG. 3

30
WRITE MODE DETERMINATION CIRCUIT
310
GROUPING CIRCUIT
320
ERASE INTERVAL DETERMINATION CIRCUIT
330
ERASE CONTROL CIRCUIT
340

FIG. 4

WT
5SECOND
TIME
TE11
TE12
TE13
TE14
ER
TI11
TI12
TI13
TI14

FIG. 5A

Peak
Power(mW)
40
Time(s)

FIG. 5B

Peak
Power(mW)
10
Time(s)

FIG. 6

WT
10SECOND
TIME
TE21
TE22
TE23
TE24
TE25
TE26
TE27
TE28
ER
TI21
TI22
TI23
TI24
TI25
TI26
TI27
TI28

FIG. 7A

Peak
Power(mW)
80
Time(s)

FIG. 7B

Peak
Power(mW)
10
Time(s)

TIME
30SECOND
WT
ER
TE31
TI31
TE32
TI32
TE33
TI33
TE34
TI34
TE35
TI35
TE36
TI36
TE37
TI37
TE38
TI38

FIG. 8

FIG. 9A

Peak
Power(mW)
160
Time(s)
Peak
Power(mW)
20
Time(s)

FIG. 9B

FIG. 10

START
S101
IS THE SUPERBLOCK PERFORMING A WRITE OPERATION?
N
Y
S103
DETERMINING THE WRITE OPERATION MODE
SEQUENTIAL WRITE
EXTERNAL RANDOM WRITE
INTERNAL RANDOM WRITE
S105
S107
S109
WRITE TIME = a
WRITE TIME = b
WRITE TIME = c
S111
DETERMINING ERASING UNITS BY GROUPING MEMORY BLOCKS
S113
DETERMINING AN ERASE INTERVAL
S115
ERASING THE PRELIMINARY SUPERBLOCK USING THE ERASING UNITS AND THE ERASE INTERVAL
END

Europäisches Patentamt
European Patent Office
Office européen des brevets

# EUROPEAN SEARCH REPORT

Application Number
EP 24 21 8920

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2019/087128 A1 (SHIN BEOM-JU [KR])<br>21 March 2019 (2019-03-21)<br>* figures 1,6,8-9 *<br>----- | 1-7,<br>11-17<br>8-10 | INV.<br>G06F3/06<br>G06F12/02<br>G11C16/16 |
| X<br><br>Y<br><br>A | US 2022/076755 A1 (KIM IN-SU [KR] ET AL)<br>10 March 2022 (2022-03-10)<br>* figures 1-2,4,14-15 *<br>----- | 1-5,<br>11-15<br>6,7,16,<br>17<br>8-10 | |
| Y | US 2019/179698 A1 (LIU TING-YU [TW] ET AL)<br>13 June 2019 (2019-06-13)<br>* figure 2A *<br>----- | 6,7,16,<br>17 | |
| | | | TECHNICAL FIELDS SEARCHED (IPC) |
| | | | G06F<br>G11C |

The present search report has been drawn up for all claims

| Place of search | Date of completion of the search | Examiner |
|---|---|---|
| Munich | 7 May 2025 | Havard, Corinne |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 21 8920

This annex lists the patent family members relating to the patent documents cited in the above-mentioned European search report. The members are as contained in the European Patent Office EDP file on
The European Patent Office is in no way liable for these particulars which are merely given for the purpose of information.

07-05-2025

| Patent document cited in search report | Publication date | Patent family member(s) | Publication date |
|---|---|---|---|
| US 2019087128 A1 | 21-03-2019 | CN 109524044 A | 26-03-2019 |
| | | KR 20190031693 A | 27-03-2019 |
| | | US 2019087128 A1 | 21-03-2019 |
| US 2022076755 A1 | 10-03-2022 | CN 114168502 A | 11-03-2022 |
| | | EP 3968329 A1 | 16-03-2022 |
| | | KR 20220033784 A | 17-03-2022 |
| | | US 2022076755 A1 | 10-03-2022 |
| | | US 2023005547 A1 | 05-01-2023 |
| US 2019179698 A1 | 13-06-2019 | CN 109902039 A | 18-06-2019 |
| | | TW 201926350 A | 01-07-2019 |
| | | US 2019179698 A1 | 13-06-2019 |

EPO FORM P0459

For more details about this annex : see Official Journal of the European Patent Office, No. 12/82